# EUROPÄISCHE PATENTSCHRIFT

(11) **EP 1 651 019 B1**
(45) Veröffentlichungstag und Bekanntmachung des Hinweises auf die Patenterteilung: **14.05.2008**
(21) Anmeldenummer: 05019616.1
(22) Anmeldetag: 09.09.2005
(51) Int. Cl.: H05K 3/12, B41F 15/36, B41N 1/24, B21D 5/02

(54) **Druckschablone, Spannrahmen zum Einspannen der Druckschablone sowie Verfahren und Vorrichtung zur Herstellung der Druckschablone**
Stencil, frame to stretch said stencil as well as process and device to manufacture stencil
Ecran, cadre pour tendre l'écran ainsi que procédé et machine pour fabriquer l'écran

(30) Priorität: 25.10.2004 DE 102004051935; 04.03.2005 DE 202005003738 U
(43) Veröffentlichungstag der Anmeldung: 26.04.2006
(73) Patentinhaber: METAQ GmbH, 42389 Wuppertal (DE)
(72) Erfinder: Meyer, Uwe, 42281 Wuppertal (DE); Von Stauffenberg, Heimeran, 8053 Zürich (CH); Pöhlmann, Ernst, 82544 Egling (DE)
(74) Vertreter: Gehrsitz, Stefan

(56) Entgegenhaltungen:
- EP-A- 1 308 275
- WO-A-03/093012
- US-A- 3 715 907
- US-A- 3 855 840
- US-A- 4 341 104
- US-A- 5 819 651
- US-B1- 6 189 448
- PATENT ABSTRACTS OF JAPAN Bd. 2000, Nr. 13, 5. Februar 2001 (2001-02-05) & JP 2000 301690 A (KENSEIDOU KAGAKU KOGYO KK), 31. Oktober 2000 (2000-10-31)
- PATENT ABSTRACTS OF JAPAN Bd. 1995, Nr. 07, 31. August 1995 (1995-08-31) & JP 07 109066 A (SONY CORP), 25. April 1995 (1995-04-25)

## Beschreibung

Die Erfindung betrifft eine Druckschablone nach dem Oberbegriff des Anspruchs 1, die Verwendung eines Spannrahmens zum Einspannen einer solchen Druckschablone, sowie ein Verfahren zur Herstellung einer solchen Druckschablone.

Druckschablonen nach dem Oberbegriff des Anspruchs 1 werden beispielsweise für den Auftrag von Lotpaste auf elektronische Leiterplatten mittels eines Siebdruckverfahrens eingesetzt. Hierbei wird die Lotpaste auf die Leiterplatten aufgetragen, indem diese durch die Öffnungen der Druckschablone, welche das Druckmuster bilden, hindurch auf die Leiterplatte gedrückt wird, so dass dort Lotpads entstehen, in welche schließlich die elektronischen Bauteile in bekannter Weise eingesetzt werden können. Derartige Druckschablonen können jedoch ganz allgemein bei Siebdruckverfahren verwendet werden, in denen pastöse Druckmassen auf einen Träger aufgebracht werden, indem die Druckmasse durch ein Druckmuster, welches üblicherweise im Zentrum der Schablone angeordnet ist, gedrückt wird.

Eine Druckschablone nach dem Oberbegriff des Anspruchs 1 ist aus der US 5,819,651 bekannt. Weitere Druckschablonen der eingangs genannten Art sowie Spannrahmen zum Einspannen solche Druckschablonen für den Siebdruckvorgang sind weiterhin aus der EP 1 308 275 B1 und der WO 03/093012 A1 bekannt. Aus der EP 1 308 275 B1 ist eine Druckschablone mit an den Rändern angeordneten, mit der Schablonenfolie fest verbundenen und im wesentlichen aus zwei Schenkeln bestehenden Profilleisten bekannt, deren Schenkel in Richtung zur Schablonenmitte hinweisen, wobei die Öffnungen der im wesentlichen U-förmigen oder spitzwinkeligen Querschnitte der Schenkel der Schablonenmitte zugewandt sind. Um diese Schablone weitgehend plan in einer Ebene gespannt zu halten, ist ein Spannrahmen mit zwei gegenüber liegenden, elastische Spannmittel tragenden Rahmenprofilen vorgesehen, wobei die Spannmittel mittels Eingriffsmitteln unter Spannung in die Profilleisten der Schablone eingreifen und die Spannmittel in Richtung zu den Rahmenprofilen hin vorspannbar sind.

In der WO 03/093012 A1 sind Druckschablonen beschrieben, welche an zumindest zwei gegenüberliegenden Seiten Einspannelemente aufweisen, in die Eingriffselemente eines Zwischenrahmens eingreifen können. Der Zwischenrahmen wiederum weist Eingriffsflächen auf, in die Eingriffsmittel eines Spannrahmens eingreifen können, um den Zwischenrahmen und die darin befestigte Druckschablone zu spannen. Die Einspannelemente an der Schablone sind in einem Ausführungsbeispiel durch umgebogene Zinken gebildet, welche am Schablonenrand ausgeschnitten sind. In einem anderen Ausführungsbeispiel ist der äußere Rand der Druckschablone zur Bildung der Einspannelemente um einen spitzen Winkel umgebogen, wobei zur Erleichterung des Umbiegens der äußeren Ränder im Bereich der Biegelinie Einschnitte in Form von kreisrunden Öffnungen nach Art einer Perforation aufweist. In einem weiteren Ausführungsbeispiel ist der Zwischenrahmen am äußeren Rand der Druckschablone durch Kleben oder Vulkanisieren befestigt.

Die bekannten Druckschablonen sind in der Herstellung aufwendig und teuer, weil die Einspannelemente, in welche die Eingriffsmittel des Spannrahmens eingreifen sollen, in mehreren Einzelschritten und unter Verwendung zusätzlicher Bestandteile, beispielsweise eines Zwischenrahmens wie in der WO 03/093012 A1 oder von Profilleisten wie in der EP 1 308 275 B1 beschrieben, hergestellt werden müssen.

Hiervon ausgehend liegt der Erfindung die Aufgabe zugrunde, eine Druckschablone der eingangs genannten Art bereit zu stellen, welche ohne die Verwendung zusätzlicher Bestandteile zum Einspannen in einen Spannrahmen konfektioniert werden kann, ohne dass hierfür in den Randbereich der Druckschablone Einschnitte, beispielsweise in der Form von Löchern, eingebracht werden müssen.

Gelöst wird diese Aufgabe mit einer Druckschablone mit den Merkmalen des Anspruchs 1. Bevorzugte Ausgestaltungen der Druckschablone sind den abhängigen Ansprüchen 2 bis 8 zu entnehmen. Zur Lösung der Aufgabe trägt weiterhin die Verwendung eines Spannrahmens zum Einspannen einer solchen Druckschablone nach dem Anspruch 9 sowie ein Verfahren zur Herstellung einer solchen Druckschablone nach Anspruch 10 bei.

Die Erfindung geht von dem Gedanken aus, dass eine Druckschablone der eingangs genannten Art zum Einspannen in einen Spannrahmen wesentlich einfacher und günstiger als nach dem Stand der Technik konfektioniert werden kann, wenn die äußeren Ränder der Druckschablone an zumindest zwei gegenüberliegenden Seiten einschnittfrei, also insbesondere ohne das Einbringen von Löchern oder Öffnungen, umgebogen werden, damit die Eingriffsmittel des Spannrahmens unmittelbar, also insbesondere ohne einen die Eingriffsmittel des Spannrahmens unmittelbar, also insbesondere ohne einen Zwischenrahmen oder ohne die Verwendung von Profilleisten, welche auf der Schablone befestigt werden müssen, eingreifen können.

Die bekannten Druckschablonen zur Verwendung in Siebdruckverfahren werden üblicherweise aus relativ sprödem Edelstahlblech mit einer hohen Zugfestigkeit und hoher Härte hergestellt. Aufgrund dieser Materialeigenschaften der Schablone war es allerdings bislang nicht möglich, die äußeren Ränder der Schablone über die gesamte Seitenlänge einfach umzubiegen. Um ein Umbiegen der äußeren Ränder überhaupt zu ermöglichen wurde bereits im Stand der Technik, beispielsweise der EP 0 643 902 B1 und der GB 2 364 961-A, vorgeschlagen, Perforationslöcher oder längliche Schlitze in den Randbereich der Schablone einzuschneiden, damit dieser Randbereich biegbar wird. Die Erfindung stellt nunmehr ein Verfahren zur Verfügung, welches es ermöglicht, die äußeren Ränder eines Edelstahlblechs umzubiegen ohne vorher eine Perforation einzubringen, beispielsweise in der Form von längs der Seitenkante verlaufende Löcher oder Öffnungen, oder die Dicke der Schablone im Randbereich, beispielsweise durch Ätzen, zu verringern.

Zur Herstellung der erfindungsgemäßen Druckschablone wird eine Biegevorrichtung zum Umbiegen der äußeren Ränder des Edelstahlblechs mit einem Gesenk und einem relativ zum Gesenk bewegbaren Oberstempel sowie einen Auflagetisch verwendet, wobei der Auflagetisch schwenkbar am Gesenk angelenkt ist. Bei dem Verfahren zur Herstellung der erfindungsgemäßen Druckschablone wird zunächst das Edelstahlblech auf den Auflagetisch gelegt und dort ausgerichtet und anschließend der Oberstempel in Richtung des Gesenks abgesenkt und gleichzeitig der Auflagetisch in Richtung des Oberstempels geschwenkt, um so den äußeren Rand des Edelstahlblechs umzubiegen. Durch dieses Vorgehen wird vermieden, dass sich das Edelstahlblech während des Absenkens des Oberstempels auf die Oberfläche des Edelstahlblechs verwindet, wodurch eine unsaubere Biegelinie entstehen würde und in der Folge ein Verwinden des Edelstahlblechs im zentralen Schablonenbereich. Dieser Vorgang wird an der dem umgebogenen Rand gegenüberliegenden Seite oder an den übrigen drei Seiten des rechteckigen Edelstahlblechs wiederholt.

In einer bevorzugten Ausführungsform der Biegevorrichtung ist der Oberstempel bevorzugt plattenförmig ausgebildet mit einer spitz zulaufenden Biegekante. An der Oberseite des Gesenks ist eine Nut angeordnet, welche bevorzugt im Querschnitt rechteckig ausgebildet ist und parallel zur Biegekante des Oberstempels verläuft. Der Oberstempel presst das Blech bei der Durchführung des Verfahrens in diese Nut, um im Blech eine Biegelinie zu definieren. Nachdem der Oberstempel das Blech in die Nut gepresst hat, wird der Biegetisch in Richtung des Oberstempels weitergeschwenkt, bis der Rand des Blechs um den gewünschten Biegewinkel umgebogen ist. Am Gesenk der Biegevorrichtung ist bevorzugt ein Anschlag zum Anlegen der Kante des zu biegenden Edelstahlblechs angeordnet. Der Auflagetisch ist um eine parallel zur Biegekante des Oberstempels verlaufende Achse in Richtung des Oberstempels schwenkbar. Die Schwenkachse liegt bevorzugt unterhalb der Nut an der Gesenkoberseite und unterhalb der Auflagefläche des Auflagetisches. Zum Verschwenken des Auflagetisches ist bevorzugt ein Verschwenkantrieb und zum Senken und Heben des Oberstempels ist ein Stempelantrieb vorgesehen. Der Verschwenkantrieb und der Stempelantrieb sind in einem bevorzugten Ausführungsbeispiel so miteinander gekoppelt, dass der Auflagetisch in Richtung des Oberstempels geschwenkt wird, sobald der Oberstempel auf das Gesenk abgesenkt wird.

Mit dem beschriebenen Verfahren und mittels der beschriebenen Vorrichtung können die äußeren Ränder einer Edelstahl-Druckschablone an zumindest zwei gegenüberliegenden Seiten jedoch auch an allen vier Seiten einer rechteckigen Druckschablone umgebogen werden, ohne dass sich die Schablone in ihrem zentralen Bereich verwindet. Um auch die Randbereich von dickeren und/oder härteren Edelstahlblechen umbiegen zu können, sind bei der erfindungsgemäßen Druckschablone an zumindest zwei gegenüberliegenden Seiten am äußeren Rand mittig oder zumindest in etwa in der Mitte Einschnitte vorgesehen, wobei der übrige Randbereich der Druckschablone einschnittfrei und insbesondere ohne eine Perforation ausgebildet ist. Diese Einschnitte werden vor dem Umbiegen des Randes an den Seitenkanten der Druckschablone eingeschnitten oder ausgestanzt, um ein Verwinden des zentralen Schablonenbereichs beim Umbiegen des äußeren Randes zu verhindern. Die Ränder an den Seiten der Druckschablone werden dann nach dem erfindungsgemäßen Verfahren umgebogen. In die so umgebogenen Ränder der Druckschablone können die Eingriffsmittel einer Spannvorrichtung unmittelbar eingreifen, um die Schablone weitgehend plan in einer Ebene zu spannen. Auf die Verwendung zusätzlicher Spannrahmen, wie sie bei den aus dem Stand der Technik bekannten Druckschablonen erforderlich sind, kann verzichtet werden.

Nachfolgend wird die Erfindung anhand eines Ausführungsbeispiels unter Bezugnahme auf die begleitenden Zeichnungen näher erläutert. Die Zeichnungen zeigen:
- **Figur 1a:**: Perspektivische Darstellung einer an den Rändern umgebogenen Druckschablone, dargestellt im Bereich einer Ecke;
- **Figur 1b:**: Seitenansicht der Druckschablone von Figur 1a;
- **Figur 1c:**: Perspektivische Darstellung der Druckschablone von Figur 1a mit an den Rändern eingeschnittenen V-förmigen Einschnitten, in einem Zwischenschritt des Verfahrens zur Herstellung dieser Druckschablone;
- **Figur 2:**: Seitenansicht einer Vorrichtung zum Umbiegen der äußeren Ränder eines Edelstahlblechs;
- **Figur 3:**: Schematische Darstellung einer Spannvorrichtung zum Einspannen einer Druckschablone;
- **Figur 4:**: Detailansicht der Spannvorrichtung von Figur 4 im Bereich der Spannklauen.

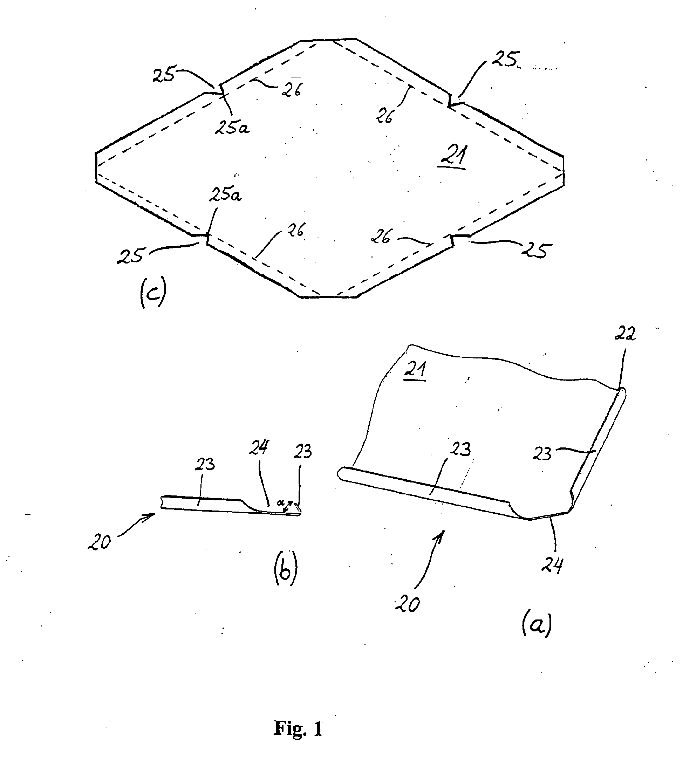

In Figur 1a ist eine im Wesentlichen rechteckige Druckschablone 20 perspektivisch im Bereich einer Ecke dargestellt. Die Druckschablone 20 ist aus einem rechteckigen Edelstahlblech mit einer Zugfestigkeit von etwa 1300 bis 1500 N/mm² und einer Rockwell-Härte von etwa 40 bis 50 RC (entsprechend einer Vickers-Härte von etwa 400 bis 500) hergestellt. Hierzu werden beispielsweise Edelstahlbleche mit einer Zusammensetzung von 0,055 % C, 1,7 % MN, 0,18 % CO, 0,002 % S, 0,28 % SI, 0,45 % CU, 8,02 % NI, 18,31 % CR, 0,053 % N, 0,034 % P, 0,46 % MO und REM % FE oder mit 0,082 % C, 0,96 % MN, 0,12 % CO, 0,003 % S, 0,52 % SI, 0,18 % CU, 7,11 % NI, 17,28 % CR, 0,04 % N, 0,023 % P, 0,23 % MO und BAL % FE verwendet. Die Größe des rechteckigen Edelstahlblechs liegt beispielsweise bei 532 mm im Quadrat. Die Dicke des Edelstahlblechs liegt in der Regel oberhalb von 100 µm und kann bis zu 1000 µm betragen. Typischerweise liegt die Dicke oberhalb von 100 µm bis zu 500 µm und in den meisten Fällen zwischen 100 und 200 µm. Vor dem Umbiegen der äußeren Ränder 23 des rechteckigen Edelstahlblechs werden zunächst die Ecken ausgestanzt oder ausgeschnitten, wie aus Figur 1a ersichtlich. Hierzu können herkömmliche Stanz- oder Schneidwerkzeuge, einschl. Laser, verwendet werden.

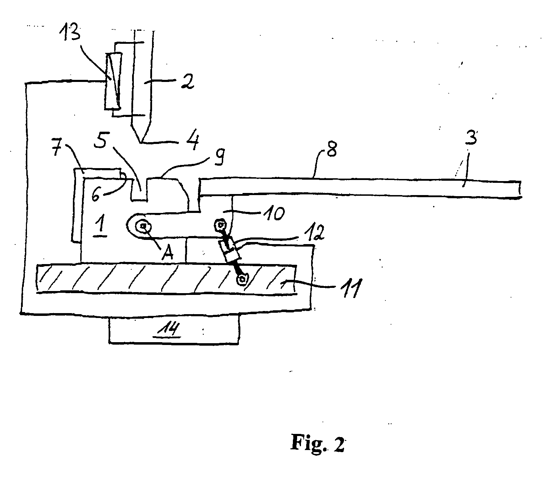

Zum anschließenden Umbiegen der äußeren Ränder 23 entweder an zwei gegenüberliegenden Seiten des rechteckigen Edelstahlblechs oder an allen vier Seiten wird die unter Bezugnahme auf Figur 2 nachfolgend beschriebene Biegevorrichtung verwendet. Diese Biegevorrichtung weist ein Gesenk 1, einen relativ zum Gesenk bewegbaren Oberstempel 2 sowie einen Auflagetisch 3 auf. Der Auflagetisch 3 ist um eine Achse A schwenkbar am Gesenk 1 angelenkt. Der Oberstempel 2 ist plattenförmig ausgebildet und erstreckt sich in der Ebene, die senkrecht zur Papierebene der Figur 2 verläuft, über eine Länge, die etwas größer als die Abmessungen des zu biegenden Edelstahlblechs sind. An der Unterseite des Oberstempels 2, welche dem Gesenk 1 zugewandt ist, ist die Kante des plattenförmigen Oberstempels 2 zur Bildung einer Biegekante 4 angespitzt. An der Oberseite 9 des Gesenks 1 ist eine rechteckige Nut 5 eingeschnitten, welche der Biegekante 4 in der Ausgangsstellung der Biegevorrichtung, wie sie in Figur 2 gezeigt ist, gegenüber liegt. Die Nut 5 verläuft somit unterhalb und parallel zur Biegekante 4 des Oberstempels 2. An der Oberseite des Gesenks 1 ist ferner im Abstand von der Nut 5 eine Anschlagkante 6 vorgesehen, welche von der parallel zur Nut 5 verlaufenden Seitenfläche eines Anschlagelements 7 gebildet ist.

Der Auflagetisch 3 weist eine Auflagefläche 8 auf, welche mit der Oberseite 9 des Gesenks 1 fluchtet. An der Unterseite des Auflagetischs 3 ist an seinem vorderen, dem Gesenk 1 zugewandten Ende ein L-förmiger Schwenkarm 10 befestigt. Das Ende des Schwenkarms 10 ist in einer Lagerung im Gesenk 1 um die Schwenkachse A schwenkbar gelagert. Die Schwenkachse A liegt damit unterhalb des Grunds der Nut 5 und auch unterhalb der Auflagefläche 8 des Auflagetisches 3.

Das Gesenk 1 ist auf einer Grundplatte 11 befestigt. Zum Verschwenken des Auflagetisches 3 ist ein Schwenkantrieb 12 vorgesehen. Dieser wird von einem Hydraulik-Zylinder gebildet, dessen Enden an dem Schwenkhebel 10 und der Grundplatte 11 angelenkt sind. Der Schwenkantrieb 12 kann alternativ auch von einem elektrischen Antrieb gebildet sein. Zum Heben und Senken des Oberstempels 2 ist ein Stempelantrieb 13 vorgesehen. Dieser kann ebenfalls durch einen hydraulischen Hubzylinder oder auch durch einen Motor, beispielsweise einen Elektromotor, gebildet sein.

Der Stempelantrieb 13 und der Schwenkantrieb 12 sind über eine Steuerung 14 so miteinander gekoppelt, dass der Auflagetisch 3 in Richtung des Oberstempels geschwenkt wird, sobald der Oberstempel 2 auf das Gesenk 1 abgesenkt wird. Die Absenkbewegung des Oberstempels 13 und die Hochschwenkbewegung des Auflagetisches 3 erfolgen dadurch synchron.

Zum Umbiegen des äußeren Rands eines Edelstahlblechs wird dieses zunächst auf die Auflagefläche 8 des Auflagetisches 3 gelegt und in Richtung des Anschlagelements 7 geschoben, um bündig an der Anschlagkante 6 anzuliegen. Anschließend wird der Oberstempel 2 in Richtung des Gesenks 1 abgesenkt und gleichzeitig der Auflagetisch 3 in Richtung des Oberstempels 2 hochgeschwenkt. Der Oberstempel 2 senkt sich zunächst so weit ab, bis er die Oberfläche des darunter liegenden Blechs berührt. Bei weiterem Absenken des Oberstempels 2 drückt dieser das Blech in die Nut 5, wodurch entlang der Biegekante 4 des Oberstempels 2 im Blech eine Biegelinie definiert wird. Die zur Biegelinie benachbarten Bereiche der Blechunterseite liegen an den Oberkanten der Nut 5 auf. Bei weiterem Absenken des Oberstempels 2 wird das Blech im Bereich der Biegelinie weiter in die Nut 5 hineingedrückt, wodurch der freie Randbereich des Blechs, dessen Kante an der Anschlagkante 6 anliegt wie auch der zentrale Bereich des Blechs angehoben werden. Um Verwindungen des Blechs zu vermeiden wird der zentrale Bereich des Blechs durch das Hochschwenken des Auflagetisches 3 gestützt. Die Geschwindigkeiten der Absenkbewegung des Oberstempels und der Hochschwenkbewegung des Auflagetisches 3 sind hierbei so aufeinander abgestimmt, dass zumindest der zentrale Bereich des Blechs während des Biegevorgangs ständig in Kontakt mit der Auflagefläche 8 des Auflagetisches 3 ist. Der Biegetisch wird danach weiter hochgeschwenkt, bis der äußere Rand des Blechs um den gewünschten Biegewinkel (zzgl. zu berücksichtigender Rückbiegewinkel) umgebogen ist. Dieser Biegevorgang kann dann an der gegenüberliegenden Seite oder auch an den übrigen drei Seiten des rechteckigen Edelstahlblechs in der vorbeschriebenen Weise wiederholt werden, um die äußeren Ränder des Blechs entweder an zwei gegenüberliegenden Seiten oder an allen vier Seiten umzubiegen.

Zum Einspannen der so gebogenen Druckschablone 20 in Einspannrahmen haben sich Biegewinkel a (Figur 1b) von 40° bis 80°, insbesondere von etwa 75° ± 5° als vorteilhaft erwiesen, wobei die umgebogenen Schenkel spitzwinklig in die Schablonenmitte weisen. Die umgebogenen Ränder 23 der Druckschablone 20 können entweder, wie in der Darstellung der Figur 1b gezeigt, gerade oder auch, wie aus der Darstellung der Figur 1a ersichtlich, gebogen sein, insbesondere kreissegmentförmig oder parabelförmig. Die Form der umgebogenen Ränder 23, welche Einspannelemente zum Eingreifen von Eingriffsmitteln des Spannrahmens bilden, kann der Form der Eingriffsmittel angepasst werden, damit ein möglichst guter Sitz der Eingriffsmittel in den Einspannelementen 23 der Druckschablone 20 gewährleistet wird. Zur Formung der umgebogenen Ränder können an der Biegevorrichtung hier nicht zeichnerisch dargestellte Umformelemente, beispielsweise Pressstangen, vorgesehen sein.

Vor oder nach dem Umbiegen der äußeren Ränder der Druckschablone 20 wird im zentralen Schablonenbereich 21 das Druckmuster in Form von Öffnungen bzw. Einschnitten mit bekannten Verfahren, beispielsweise Laserschneiden oder Ätzen, eingebracht. Die derart konfektionierte Schablone kann dann bestimmungsgemäß im Siebdruckverfahren verwendet werden, indem sie in eine Spannvorrichtung eingespannt wird. Die Spannvorrichtung weist hierzu Spannmittel mit Eingriffsmitteln auf. Die Eingriffsmittel können in die durch die umgebogenen Ränder der Druckschablone 20 gebildeten Einspannelemente 23 unmittelbar eingreifen, ohne dass ein Zwischenrahmen oder sonstige weitere Elemente, wie z. B. Profilleisten, benötigt werden. Die erfindungsgemäß konfektionierte Druckschablone 20 kann auf diese Weise in die gängigen Einspannrahmen eingespannt werden. Um einen möglichst guten Sitz der Eingriffsmittel der Spannvorrichtung zu gewährleisten, kann die Form der umgebogenen Ränder der Druckschablone beim Biegeverfahren der Form der Eingriffsmittel angepasst werden.

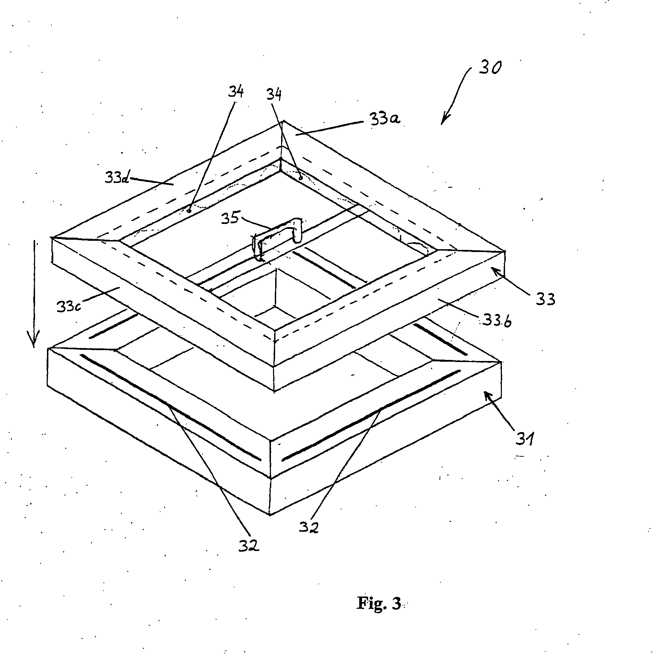

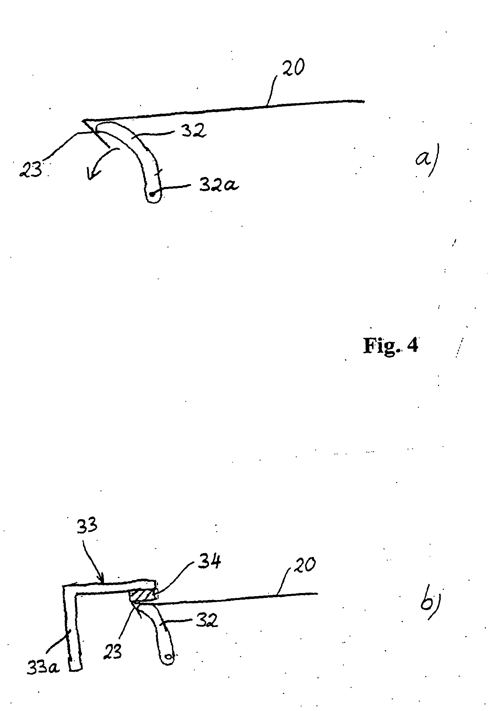

In Figur 3 ist eine Spannvorrichtung 30 zum Einspannen der Druckschablone 20 dargestellt. Der Übersichtlichkeit halber ist die Druckschablone 20 in der Darstellung der Figur 3 nicht gezeigt. Die Spannvorrichtung 30 dient dazu, die Druckschablone 20 möglichst eben einzuspannen um das Siebdruckverfahren durchführen zu können. Die Spannvorrichtung 30 umfasst einen rechteckigen Spannrahmen 31, an dem Spannmittel angeordnet sind. Diese Spannmittel weisen Eingriffsmittel 32 auf, die in ihrer Spannposition unmittelbar in die Einspannelemente 23 der Druckschablone 20 eingreifen, um diese möglichst plan in einer Ebene zu spannen. Die Spannmittel weisen darüber hinaus feder- oder druckbelastete Spannelemente auf, welche die Eingriffsmittel 32 von einer Ruhelage in ihre Spannlage bringen. Die Spannelemente können entweder manuell oder maschinell betätigt werden. Bei den Eingriffsmitteln 32 handelt es sich bevorzugt um Spannklauen 32, welche in den Detaildarstellungen der Figur 5 dargestellt sind. Diese Spannklauen 32 sind um eine Achse 32a schwenkbar gelagert und können - manuell oder maschinell betätigt - von einer Ruheposition in eine Spannposition verschwenkt werden. In der Spannposition greift das Ende jeder Spannklaue 32 in die Einspannelemente 23, also in den umgebogenen Rand der Druckschablone 20, ein - wie aus den Figuren 4a und 4b ersichtlich - und drückt den umgebogenen Rand 23 der Druckschablone 20 nach außen. Da bevorzugt an jeder Seite des Spannrahmens 31 derartige Spannklauen 32 angeordnet sind, wird die Druckschablone 20 auf diese Weise an allen vier Seiten nach außen gedrückt und auf diese Weise allseitig vorgespannt.

Um zu verhindern, dass der umgebogene Rand 23 der Druckschablone in der Spannposition aus der Spannklaue 32 herausrutscht, ist ein Halterahmen 33 vorgesehen, der auf den Spannrahmen 31 absenkbar ist, um die Druckschablone 20 gegen die Eingriffsmittel 32, also gegen die Spannklauen, zu drücken. Der Halterahmen 33 kann entweder manuell oder mittels einer Heb- und Senkpneumatik auf den Spannrahmen 31 abgesenkt bzw. von diesem wieder abgehoben werden. Der Halterahmen 33 ist aus vier, rechteckig zusammengesetzten L-förmigen Profilen 33a - 33d gebildet. Bei abgesenktem Halterahmen 33 übergreifen diese L-förmigen Profile 33a - 33d den Spannrahmen 31 zumindest teilweise. Die Unterseite des horizontalen Schenkels jedes L-förmigen Profils 33a - 33d drückt bei abgesenktem Halterahmen 33 den Randbereich der Druckschablone 20 auf die Spannklaue 32 und verhindert dadurch, dass die Einspannelemente der Druckschablone 20, also deren umgebogenen Ränder 23, beim Umlegen der Spannklauen 32 in die Spannposition aufgebogen werden.

Um die Oberseite der Druckschablone 20 beim Absenken des Halterahmens 33 nicht zu beschädigen, ist an der Unterseite des Halterahmens 33 in dem Bereich, der beim Absenken auf der Oberseite der Druckschablone 20 zur Anlage kommt, ein um das Rahmenprofil umlaufender Streifen 34 aus einem weichen Material, beispielsweise aus Moosgummi, Leder oder Stoff, angebracht. Dieser umlaufende Streifen 34 ist in Figur 4b zeichnerisch dargestellt. Um den Halterahmen 33 manuell auf den Spannrahmen 31 absenken zu können, ist an dem Halterahmen 33 bevorzugt ein Griff 35 vorgesehen (Figur 3).

In Figur 1c ist die Druckschablone in einem Zwischenschritt des erfindungsgemäßen Verfahrens gezeigt. Um zu verhindern, dass sich die Druckschablone in ihrem zentralen Bereich, also im Schablonenbereich 21, verwindet, werden vor dem Umbiegen der äußeren Ränder mittig oder zumindest nahe der Mitte an den sich gegenüberliegenden Seiten, welche anschließend zur Bildung der Einspannelemente 23 umgebogen werden sollen, Einschnitte 25 eingebracht. Hierfür können herkömmliche Stanz- oder Schneidwerkzeuge, wie zum Beispiel Schneidlaser, verwendet werden. Die Einschnitte 25 sind bevorzugt - wie in Figur 1c dargestellt - dreieckig bzw. V-förmig ausgebildet. An jeder Seite des Edelstahlblechs wird höchstens ein solcher Einschnitt 25 eingeschnitten.

Die mit den Einschnitten 25 versehene Ränder der Druckschablone werden anschließend mit dem vorbeschriebenen Verfahren und mittels der vorbeschriebenen Vorrichtung zur Durchführung des Verfahrens umgebogen, wobei die parallel zu den Kanten des Edelstahlblechs verlaufende Biegekanten, welche in Figur 1c mit Bezugszeichen 26gestrichelt dargestellt sind, bevorzugt den Grund 25a der Einschnitte 25 schneidet bzw. berühren. Die derart umgebogenen Ränder des Edelstahlblechs bilden die Einspannelemente 23, in die wiederum die Eingriffsmittel einer Spannvorrichtung unmittelbar eingreifen können, um die Druckschablone 20 weitgehend plan in einer Ebene zu spannen.

## Patentansprüche

1. Druckschablone (20) aus einem Edelstahlblech mit einem zentralen Schablonenbereich (21) und einem Randbereich (22), in dem Einspannelemente (23) zum Einspannen der Druckschablone (20) in eine Spannvorrichtung angeordnet sind, **dadurch gekennzeichnet, dass** an zumindest zwei gegenüberliegenden Seiten der Druckschablone am äußeren Rand in etwa mittig Einschnitte (25) vorgesehen sind und dass wenigstens die äußeren Ränder dieser beiden gegenüberliegenden Seiten der Druckschablone (20) umgebogen sind, um Einspannelemente (23) zum unmittelbaren Eingriff von Eingriffsmitteln der Spannvorrichtung zu bilden.

2. Druckschablone nach Anspruch 1, **dadurch gekennzeichnet, dass** die Einschnitte (25) dreieckig bzw. V-förmig sind.

3. Druckschablone nach Anspruch 2, **dadurch gekennzeichnet, dass** an den umgebogenen äußeren Rändern bis auf die Einschnitte (25) keine weiteren Einschnitte oder Bohrungen vorhanden sind.

4. Druckschablone nach einem der voranstehenden Ansprüche, **dadurch gekennzeichnet, dass** die Eckbereiche (24) des Edelstahlblechs ausgestanzt oder ausgeschnitten sind.

5. Druckschablone nach einem der voranstehenden Ansprüche, **dadurch gekennzeichnet, dass** die umgebogenen Ränder mit dem ebenen Bereich der Schablone einen Winkel zwischen 40° und 85°, bevorzugt zwischen 60° und 80° einschließen.

6. Druckschablone nach einem der voranstehenden Ansprüche, **dadurch gekennzeichnet, dass** das Edelstahlblech eine Zugfestigkeit von mehr als 1800 N pro mm² aufweist.

7. Druckschablone nach einem der voranstehenden Ansprüche, **dadurch gekennzeichnet, dass** das Edelstahlblech eine Härte nach Rockwell von etwa 40 bis 50 RC aufweist.

8. Druckschablone nach einem der voranstehenden Ansprüche, **dadurch gekennzeichnet, dass** die Dicke des Edelstahlblechs zwischen 100 µm und 1 mm liegt.

9. Verwendung eines Spannrahmens mit Spannmittel, welche Eingriffsmittel umfassen, zum Einspannen einer Druckschablone (20) nach einem der Ansprüche 1 bis 8, **dadurch gekennzeichnet, dass** die Eingriffsmittel unmittelbar in die von den umgebogenen Rändern gebildeten Einspannelemente (23) der Druckschablone eingreifen, um diese möglichst plan in einer Ebene zu spannen.

10. Verfahren zur Herstellung einer Druckschablone nach einem der Ansprüche 1 bis 8 aus einem Edelstahlblech, mit einer Vorrichtung, welche ein Gesenk (1) und einen relativ zum Gesenk bewegbaren Oberstempel (2) sowie einen Auflagetisch (3) zur Aufnahme des zu biegenden Blechs aufweist, wobei zunächst das Edelstahlblech auf den Auflagetisch (3) gelegt und anschließend der Oberstempel (2) in Richtung des Gesenks (1) abgesenkt und gleichzeitig der Auflagetisch (3) in Richtung des Oberstempels (2) geschwenkt wird, um so den äußeren Rand des Edelstahlblechs umzubiegen.

## Claims

1. Printing screen (20) made of a stainless steel sheet with a central screen area (21) and an edge area (22) in which clamping elements (23) are arranged to clamp the printing screen (20) into a fixture, **characterised in that** notches (25) are provided in the outer edge roughly in the middle on at least two facing sides of the printing screen and **in that** at least the outer edges of these two facing sides of the printing screen (20) are bent over to form clamping elements (23) for direct engagement of engagement means of the fixture.

2. Printing screen according to claim 1, **characterised in that** the notches (25) are triangular or V-shaped.

3. Printing screen according to claim 2, **characterised in that** except for the notches (25), no further notches or bores are present in the bent over outer edges.

4. Printing screen according to one of the preceding claims, **characterised in that** the corner areas (24) of the stainless steel sheet are stamped out or cut out.

5. Printing screen according to one of the preceding claims, **characterised in that** the bent over edges enclose an angle of between 40° and 85°, preferably between 60° and 80°, with the flat area of the screen.

6. Printing screen according to one of the preceding claims, **characterised in that** the stainless steel sheet exhibits a tensile strength of more than 1800 N per mm².

7. Printing screen according to one of the preceding claims, **characterised in that** the stainless steel sheet exhibits a Rockwell hardness of approximately 40 to 50 RC.

8. Printing screen according to one of the preceding claims, **characterised in that** the thickness of the stainless steel sheet lies between 100 µm and 1 mm.

9. Use of a clamping frame with clamping means which comprise engagement means for clamping a printing screen (20) according to one of claims 1 to 8, **characterised in that** the engagement means engage directly in the clamping elements (23) of the printing screen formed by the bent over edges in order to clamp this as flat as possible in one plane.

10. Method for manufacturing a printing screen according to one of claims 1 to 8 from a stainless steel sheet, with a device which exhibits a lower die (1) and an upper die (2) which can be moved relative to the lower die, and a supporting table (3) for receiving the sheet to be bent, in which firstly the stainless steel sheet is placed on the supporting table (3) and then the upper die (2) is lowered in the direction of the lower die (1) and at the same time the supporting table (3) is swivelled in the direction of the upper die (2) in order to bend over the outer edge of the stainless steel sheet.

## Revendications

1. Ecran (20) en tôle d'acier inoxydable avec une partie d'écran centrale (21) et une zone de bord (22), dans laquelle sont agencés des éléments de serrage (23) permettant de serrer l'écran (20) dans un dispositif de serrage, **caractérisé en ce que** des incisions (25) sont prévues au niveau d'au moins deux côtés opposés de l'écran sur le bord extérieur à peu près au milieu, et **en ce qu'**au moins les bords extérieurs de ces deux côtés opposés de l'écran (20) sont repliés pour former des éléments de serrage (23) pour la prise directe de moyens de prise du dispositif de serrage.

2. Ecran selon la revendication 1, **caractérisé en ce que** les incisions (25) sont triangulaires et/ou en forme de V.

3. Ecran selon la revendication 2, **caractérisé en ce qu'**il n'y a pas d'autres incisions ou alésages au niveau des bords extérieurs repliés, excepté les incisions (25).

4. Ecran selon l'une quelconque des revendications précédentes, **caractérisé en ce que** les zones de coin (24) de la tôle en acier inoxydable sont poinçonnées ou découpées.

5. Ecran selon l'une quelconque des revendications précédentes, **caractérisé en ce que** les bords repliés avec la zone plane de l'écran forment un angle compris entre 40° et 85°, de préférence entre 60° et 80°.

6. Ecran selon l'une quelconque des revendications précédentes, **caractérisé en ce que** la tôle en acier inoxydable présente une résistance à la traction supérieure à 1800 N par mm².

7. Ecran selon l'une quelconque des revendications précédentes, **caractérisé en ce que** la tôle en acier inoxydable présente une dureté Rockwell comprise entre 40 et 50 RC environ.

8. Ecran selon l'une quelconque des revendications précédentes, **caractérisé en ce que** l'épaisseur de la tôle d'acier inoxydable est comprise entre 100 µm et 1 mm.

9. Utilisation d'un cadre de serrage avec des moyens de serrage, qui comprennent des moyens de prise, pour serrer un écran (20) selon l'une des revendications 1 à 8, **caractérisée en ce que** les moyens de prise s'engagent directement dans les éléments de serrage (23) de l'écran formés par les bords repliés, pour les serrer de manière aussi plane que possible dans un plan.

10. Procédé de fabrication d'un écran selon l'une quelconque des revendications 1 à 8 en une tôle d'acier inoxydable, avec un dispositif qui présente une matrice (1) et un poinçon supérieur (2) mobile par rapport à la matrice ainsi qu'une table porte-pièce (3) pour la réception de la tôle à plier, la tôle en acier inoxydable étant d'abord posée sur la table porte-pièce (3) puis le poinçon supérieur (2) étant abaissé en direction de la matrice (1) et en même temps la table porte-pièce (3) est pivotée en direction du poinçon supérieur (2) pour replier ainsi le bord extérieur de la tôle en acier inoxydable.
